# EUROPEAN PATENT APPLICATION

(11) **EP 4 723 847 A1**
(43) Date of publication of application: **08.04.2026**
(21) Application number: 24815774.5
(22) Date of filing: 23.05.2024
(51) Int. Cl.: H10K 30/85, H10K 85/50, H10K 30/50, H10K 30/81, H10K 30/15, H10K 30/86, H10K 71/00, H10K 102/00

(54) **SOLAR CELL AND METHOD FOR FORMING SAME**

(30) Priority: 26.05.2023 KR 20230068649; 22.05.2024 KR 20240066267
(71) Applicant: Jusung Engineering Co., Ltd., Gwangju-si, Gyeonggi-do 12773 (KR)
(72) Inventor: CHO, Hong Hyeung, Gwangju-si, Gyeonggi-do 12773 (KR); KIM, Jun Ho, Gwangju-si, Gyeonggi-do 12773 (KR); LEE, In Jae, Gwangju-si, Gyeonggi-do 12773 (KR); KIM, Jae Ho, Gwangju-si, Gyeonggi-do 12773 (KR); HWANG, Chul Joo, Gwangju-Si, Gyeonggi-do 12773 (KR)
(74) Representative: Michalski Hüttermann & Partner Patentanwälte mbB
(86) International application number: PCT/KR2024/006958
(87) International publication number: WO 2024/248397

(57) **Abstract**

Embodiments relate to a solar cell and a method of forming the same, and more specifically, to a solar cell having a charge transport layer formed by a deposition process and a method of forming the same. A solar cell in accordance with an exemplary embodiment includes a substrate, a first charge transport layer provided on the substrate, a light absorption layer provided on the first charge transport layer, a second charge transport layer provided on the light absorption layer, and an electrode layer provided on the second charge transport layer. At least one of the first charge transport layer or the second charge transport layer is formed using an oxygen-containing gas and a nitrogen-containing gas.

## Description

### TECHNICAL FIELD

The present disclosure relates to a solar cell and a method of forming the same, and more specifically, to a solar cell having a charge transport layer formed by a deposition process and a method of forming the same.

### BACKGROUND ART

A solar cell is an element that is capable of converting solar energy into electrical energy using a photovoltaic effect.

To achieve high photoelectric conversion efficiency and excellent stability in the solar cell, it is essential to use not only a light absorption layer constituted by an electron donor and an electron transporter, but also a hole transport layer with excellent properties. That is, it is necessary to form the hole transport layer with a material that has high light transmittance and charge mobility and also has high stability against atmosphere and moisture.

In the related art, PEDOT:PSS, which has excellent conductivity and transmittance, has been used for the hole transport layer. However, it has the disadvantage of being a hygroscopic material with strong acidity, which corrodes an electrode and reduces performance and stability of the element. Thus, to solve this limitation, research is being conducted to improve the effective hole transport, the element performance, and the element stability using metal oxide. Particularly, nickel oxide (NiOₓ) is chemically stable even in the atmosphere and has a wide band gap, and thus, since it is expected to have excellent properties as a hole transport material, many researches are being conducted.

However, the hole transport layer containing nickel oxide (NiOₓ) in accordance with the related art has a limitation of low light transmittance. In general, the hole transport layer containing nickel oxide (NiOₓ) is formed by a deposition process using a nickel (Ni)-containing gas and an oxygen (O₂) gas. When forming the hole transport layer, there is a limitation in that the photoelectric conversion efficiency of the solar cell is deteriorated due to low light transmittance.

### [Related art document]

(Paten Document 1) KR 10-1104675 B1

### DISCLOSURE OF THE INVENTION

### TECHNICAL PROBLEM

The present disclosure provides a solar cell that increases in light transmittance to improve photoelectric conversion efficiency and a method for forming the same.

### TECHNICAL SOLUTION

In accordance with an exemplary embodiment, a solar cell includes: a substrate; a first charge transport layer provided on the substrate; a light absorption layer provided on the first charge transport layer; a second charge transport layer provided on the light absorption layer; and an electrode layer provided on the second charge transport layer, wherein at least one of the first charge transport layer or the second charge transport layer is formed using an oxygen-containing gas and a nitrogen-containing gas.

The second charge transport layer may include a hole transport layer, and the hole transport layer may be formed using the oxygen-containing gas and the nitrogen-containing gas.

The hole transport layer may have a thickness of 10 Å to 100 Å.

The hole transport layer may have light transmittance of 85% to 95% and an electrical resistance rate of 10 Ω cm to 100 Ω cm.

The hole transport layer may include a nitrogen-containing nickel oxide thin film.

In accordance with another exemplary embodiment, a method for forming a solar cell, which includes forming a charge transport layer, wherein the forming of the charge transport layer includes: preparing a substrate in a reaction space; supplying a source gas containing a metal to the reaction space; and supplying a reactant gas comprising an oxygen-containing gas and a nitrogen-containing gas to the reaction space.

At least some of the supplying of the source gas and the supplying of the reactant gas may be performed at the same time.

At least some of the supplying of the source gas and the supplying of the reactant gas may be sequentially performed.

The forming of the charge transport layer may further include: purging the reaction space into which the source gas is supplied; and purging the reaction space into which the reactant gas is supplied.

A process cycle comprising the supplying of the source gas, the purging of the reaction space into which the source gas is supplied, the supplying of the reactant gas, and the purging of the reaction space into which the reactant gas may be supplied is performed several times.

The supplying of the reactant gas may include supplying the oxygen-containing gas the nitrogen-containing gas at the same time.

The supplying of the reactant gas may include supplying the oxygen-containing gas the nitrogen-containing gas in a set order.

In the supplying of the reactant gas, the oxygen-containing gas may be supplied at the same amount as the nitrogen-containing gas or at an amount greater than that of the nitrogen-containing gas.

The forming of the charge transport layer may further include applying power for forming plasma to the reaction space, and at least a portion of the supplying of the reactant gas may be performed while the power for forming the plasma is applied to the reaction space.

The source gas may include a nickel (Ni)-containing gas, the oxygen-containing gas may include an oxygen (O₂) gas, and the nitrogen-containing gas may include a nitrous oxide (N₂O) gas.

The method may further include, after the forming of the charge transport layer, supplying the nitrogen-containing gas or the oxygen-containing gas to the reaction space.

The method may further include, after the forming of the charge transport layer, applying power for forming plasma to the reaction space.

A process cycle including the supplying of the nitrogen-containing gas or the oxygen-containing gas to the reaction space and the applying of the power for forming the plasma to the reaction space may be performed several times.

In accordance with yet another exemplary embodiment, a method for forming a solar cell, which includes forming a charge transport layer, wherein the forming of the charge transport layer includes: preparing a substrate in a reaction space; supplying a source gas containing a metal and a reactant gas containing an oxygen-containing gas to the reaction space to form a metal oxide thin film; and supplying a nitrogen-containing gas to the metal oxide thin film.

The forming of the charge transport layer may further include applying power for forming plasma to the reactant gas, wherein at least a portion of the supplying of the nitrogen-containing gas to the metal oxide thin film may be performed while the power for forming the plasma is applied to the reaction space.

### ADVANTAGEOUS EFFECTS

According to the exemplary embodiment, the light transmittance of the charge transport layer formed through the deposition process may increase.

That is, the light transmittance may increase while minimizing the deterioration in the electrical properties of the charge transport layer. Therefore, the solar light may effectively pass through the charge transport layer and be absorbed by the light absorption layer to improve the photoelectric conversion efficiency.

### BRIEF DESCRIPTION OF THE DRAWINGS

FIG. 1 is a schematic view of a solar cell in accordance with an exemplary embodiment;
FIG. 2 is a schematic view of a substrate processing apparatus for forming the solar cell in accordance with an exemplary embodiment;
FIG. 3 is a view for explaining a process of forming an electron transport layer by supplying a source gas and a reactant gas at the same time in accordance with an exemplary embodiment; and
FIG. 4 is a view for explaining a process of forming the electron transport layer by sequentially supplying the source gas and the reactant gas in accordance with an exemplary embodiment.

### MODE FOR CARRYING OUT THE INVENTION

Hereinafter, exemplary embodiments of the present invention will be described in detail with reference to the accompanying drawings. The present invention may, however, be embodied in different forms and should not be construed as limited to the embodiments set forth herein. Rather, these embodiments are provided so that the present invention will be thorough and complete, and will fully convey the scope of the present invention to those skilled in the art.

It will also be understood that when a layer, a film, a region or a plate is referred to as being 'on' another one, it can be directly on the other one, or one or more intervening layers, films, regions or plates may also be present.

Also, spatially relative terms, such as "above" or "upper" and "below" or "lower" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. In the figures, the dimensions of layers and regions are exaggerated for clarity of illustration. Like reference numerals refer to like elements throughout.

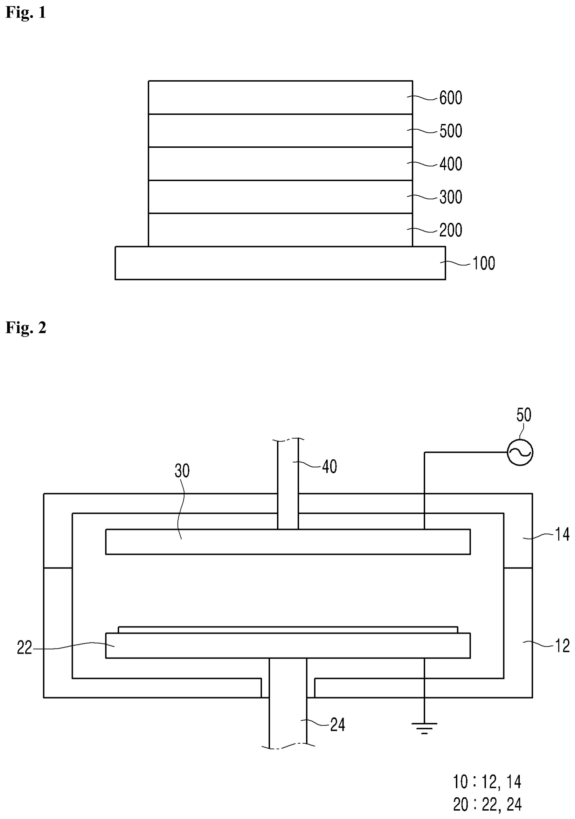

FIG. 1 is a schematic view of a solar cell in accordance with an exemplary embodiment.

Referring to FIG. 1, a solar cell in accordance with an exemplary embodiment may include a substrate 100, a first charge transport layer provided on the substrate 100, a light absorption layer 400 provided on the first charge transport layer, a second charge transport layer provided on the light absorption layer 400, and an electrode layer provided on the second charge transport layer. In addition, the solar cell may further include an electrode layer provided between the substrate 100 and the first charge transport layer. Here, the electrode layer provided between the substrate 100 and the first charge transport layer may be defined as a first electrode layer 200, and the electrode layer provided on the second charge transport layer may be defined as a second electrode layer 600.

In addition, the first charge transport layer may include an electron transport layer 300 that serves to transfer electrons generated from the light absorption layer 400 to the first electrode layer 200. The second charge transport layer may include a hole transport layer 500 that serves to transfer a hole generated from the light absorption layer 400 to the second electrode layer 600. In an embodiment of the present disclosure, at least one of the first charge transport layer or the second charge transport layer, that is, at least one of the electron transport layer 300 or the hole transport layer 500 may be formed using an oxygen-containing gas and a nitrogen-containing gas. Hereinafter, although an embodiment is described in which a hole transport layer 500 that is provided on the light absorption layer 400 through which the solar light is incident and has a relatively high need to increase in light transmittance is formed using the oxygen-containing gas and the nitrogen-containing gas, both the electron transport layer 300 or the electron transport layer 300 and the hole transport layer 500 may be formed using the oxygen -containing gas and the nitrogen-containing gas.

The substrate 100 may include a transparent substrate or an opaque substrate. When the substrate 100 includes the transparent substrate, the transparent substrate may include a glass substrate or a plastic substrate. Here, the plastic substrate may include, for example, polyethylene terephthalate (PET), polyethylene naphthalate (PEN), polypropylene (PP), polyimide (PI), or triacetyl cellulose (TAC), but is limited thereto.

The first electrode layer 200 may be provided on the substrate 100. The first electrode layer 200 may include transparent conducting oxide (TCO). For example, the transparent conductive oxide may include at least one of indium tin oxide (ITO), fluorine tin oxide (FTO), aluminum zinc oxide (AZO), gallium zinc oxide (GZO), indium zinc oxide (IZO), zinc tin oxide (ZTO), indium zinc tin oxide (IZTO), or indium gallium zinc oxide (IGZO), but is not limited thereto.

The electron transport layer 300 may be provided on the first electrode layer 200. The electron transport layer 300 may serve to transfer electrons generated from the light absorption layer 400, which will be described later, to the first electrode layer 200. As described above, the electron transport layer 300 may be used by using common materials used in the fields of manufacturing the solar cell without limitation. For example, the electron transport layer 300 may include fullerene (C60) and/or a fullerene derivative (e.g., C70, etc.) used in Perovskite solar cells. In this case, the electron transport ability may be excellent, and high thermal stability and conversion efficiency may be achieved.

The light absorption layer 400 may be provided on the electron transport layer 300. The light absorption layer 400 may include a Perovskite compound. The Perovskite compound may have an advantage of having a direct band gap, a light absorption coefficient as high as 15× 04 cm⁻¹ at approximately 550 nm, excellent charge transfer characteristics, and excellent resistance to defects. As described above, the Perovskite compound may include an ABX₃ type organic-inorganic composite Perovskite material, for example, CH₃NH₃PbI₃.

The hole transport layer 500 may be provided on the light absorption layer 400. The hole transport layer 500 may serve to transfer the hole generated from the light absorption layer 400 to the second electrode layer 600, which will be described later. Here, the hole transport layer 500 may include metal oxide containing a nitrogen (N) component. The hole transport layer 500 may include a nickel oxide (NiOₓ) thin film that is chemically stable even in the atmosphere and has a wide band gap to exhibit excellent properties as a hole transport material. Such a nickel oxide (NiOₓ) thin film is doped with nitrogen (N). That is, the hole transport layer 500 in accordance with an exemplary embodiment may include a nickel oxide thin film (N: NiOₓ) containing a nitrogen (N) component.

In the related art, the nickel oxide (NiOₓ) thin film has been used as the hole transport layer 500, and the nickel oxide (NiOₓ) thin film may be formed through a deposition process using a nickel (Ni)-containing gas and an oxygen (O₂) gas. However, when the hole transport layer is formed using the nickel (Ni)-containing gas and the oxygen (O₂) gas, there may be a limitation in that the photoelectric conversion efficiency of the solar cell is reduced due to low light transmittance. Thus, in an exemplary embodiment, the nitrogen (N) component may be contained in the hole transport layer 500 to increase in light transmittance. If the hole transport layer 500 contains a predetermined amount of nitrogen (N), deterioration in electrical characteristics may be minimized to increase in transmittance. Thus, in an exemplary embodiment, the hole transport layer 500 may be formed to contain the nitrogen (N) component, and specific details of forming the hole transport layer 500 as described above will be described later in relation to the method for forming the solar cell.

The hole transport layer 500 may have a thickness of 10 Å to 100 Å. If the thickness of the hole transport layer 500 is less than 10 Å, the hole generated from the light absorption layer 400 may not be efficiently collected and transferred to the second electrode layer 600. In addition, if the thickness of the hole transport layer 500 exceeds 100 Å, there may be a limitation in that the light transmittance decreases. Thus, the hole transport layer 500 may have a thickness of 10 Å or more and 100 Å or less.

The hole transport layer 500 may have light transmittance of 85% to 95% and electrical resistivity of 10 Ωcm to 100 Ωcm. As described above, the hole transport layer 500 may include a nickel oxide thin film (N: NiOₓ) doped with nitrogen (N). In this case, the hole transport layer 500 having excellent light transmittance of 85% to 95% and low electric resistivity of 10 Ωcm to 100 Ωcm by controlling a content of nitrogen (N) may be formed.

The second electrode layer 600 may be provided on the hole transport layer 500. The second electrode layer 600 may include transparent conducting oxide (TCO). For example, the transparent conductive oxide may include at least one of indium tin oxide (ITO), fluorine tin oxide (FTO), aluminum zinc oxide (AZO), gallium zinc oxide (GZO), indium zinc oxide (IZO), zinc tin oxide (ZTO), indium zinc tin oxide (IZTO), or indium gallium zinc oxide (IGZO), but is not limited thereto.

As described above, the solar cell in accordance with an exemplary embodiment may be a solar cell having an inverse structure, in which the hole transport layer 500 is disposed on a top surface of the light absorption layer 500 in a direction in which the solar light is incident, and the electron transport layer 400 is disposed on a bottom surface of the light absorption layer 500. However, the embodiment is not limited thereto, and the solar cell may be equally applied to a normal structure in which the electron transport layer 400 is disposed on the top surface of the light absorption layer 500 in the direction in which the solar light is incident, and the hole transport layer 600 is disposed on the bottom surface of the light absorption layer 500.

Hereinafter, a substrate processing apparatus for forming a solar cell in accordance with an exemplary embodiment and a method of forming the solar cell using the same will be described in detail.

FIG. 2 is a schematic view of a substrate processing apparatus for forming the solar cell in accordance with an exemplary embodiment.

Referring to FIG. 2, the substrate processing apparatus in accordance with an exemplary embodiment may be an apparatus for forming a hole transport layer 500 including a nitrogen (N)-doped nickel oxide thin film (N: NiOₓ) and may include a chamber, a substrate support part 20 provided in the chamber 10 to support a substrate provided in the chamber 10, a gas injection part 30 provided in the chamber 10 to face the substrate support part 20 so as to inject a process gas to the substrate support part 20, and a gas supply part 40 that supplies the process gas to the gas injection part 30. In addition, the substrate processing apparatus may include an RF power source 50 that supplies power to generate plasma within the chamber 10 and may further include a controller (not shown) that controls the RF power source 50.

The chamber 10 may provide a predetermined reaction space to maintain sealing of the reaction space. The chamber 10 may include a body 100a including an approximately circular or square-shape plane and a sidewall extending upward from the plane and having a predetermined reaction space and a cover 100b having an approximately circular or square shape and disposed on the body 100a to seal the reaction chamber 10. However, the chamber 10 is not limited thereto and may be manufactured in various shapes corresponding to a shape of the substrate. An exhaust port (not shown) may be provided in a predetermined area of a bottom surface of the chamber 10, and an exhaust tube (not shown) connected to the exhaust port may be provided outside the chamber 10.

The substrate provided in the chamber 10 may be seated on the substrate support part 20 to perform a thin film formation process. Here, the substrate may include a transparent substrate or an opaque substrate, and the transparent substrate may include a glass substrate or a plastic substrate. The substrate may be provided into the chamber 10 in a state in which a first electrode layer 200, an electron transport layer 300, and a light absorption layer 400 are already formed on the substrate. Alternatively, at least one of the first electrode layer 200, the electron transport layer 300, or the light absorption layer 400 may be formed in the same chamber 10. Also, the substrate support part 20 may include an electrostatic chuck to adsorb and maintain the substrate 10 by using electrostatic force so that the substrate 10 is seated and supported. Alternatively, the substrate support part 20 may also support the substrate 10 through vacuum adsorption or mechanical force.

The substrate support part 20 may be provided in a shape corresponding to the shape of the substrate, for example, circular or square shape. The substrate support part 20 may include a substrate support 22 on which the substrate is seated, and an elevator 24 disposed below the substrate support 22 to elevate the substrate support 22. Here, the substrate support 22 may be manufactured to be larger than the substrate, and the elevator 24 may be provided to support at least one area, for example, a central portion of the substrate support 22, and when the substrate is seated on the substrate support 22, the substrate support 22 may move to be closer to the gas injection part 20. In addition, a heater (not shown) may be installed inside the substrate support. The heater may generate heat at a predetermined temperature to heat the substrate support 22 and the substrate seated on the substrate support 22, thereby allowing a thin film to be deposited uniformly on the substrate.

At least portion of the gas supply part 40 may be installed outside the chamber 10 to supply a gas to the gas injection part 30. The gas supply part 40 may include a source gas supply part that supplies a source gas and a reactant gas supply part that supplies a reactant gas. In addition, the gas supply part 40 may further include a purge gas supply part that supplies an inert gas such as an argon (Ar) gas or a low-reactivity gas such as a nitrogen (N₂) gas.

The gas supply part 40 may not necessarily supply one gas to the gas injection part 30, but may be configured to supply a plurality of gases at the same time or to supply a selected gas of the plurality of gases.

The source gas supply part may be configured to supply a gas containing nickel (Ni) as the source gas. In addition, the reactant gas supply part may supply a reactant gas that reacts with the source gas containing nickel (Ni). Here, the reactant gas may include an oxygen-containing gas containing oxygen (O) and a nitrogen-containing gas containing nitrogen (N). The source gas and the reactant gas may be supplied to form the hole transport layer 500 on the substrate.

The gas injection part 30 may be provided at an upper side of the chamber 10 to inject the process gas toward the substrate. An upper portion of the gas injection part 30 may be connected to the gas supply part 40, and an injection hole (not shown) for injecting the process gas onto the substrate may be defined in a lower portion of the gas injection part 30. The gas injection part 30 may include a shower head having a plurality of fine injection holes. Alternatively, the gas injection part 30 may include an injector in which the injection hole having a bore relatively greater than that of the fine injection hole is defined in an end thereof. Hereinafter, the gas injection part 30 including the shower head is described as an example, but even if the gas injection part 30 includes the injector, the following embodiments may be applied as it is.

The gas injection part 30 may be manufactured in a shape corresponding to the shape of the substrate, for example, may be manufactured in an approximately circular or rectangular shape. Here, the gas injection part 30 may be provided to be spaced a predetermined distance from the sidewall and the cover 14 of the chamber 10. In addition, when the gas injection part 30 generates plasma in the reaction space inside the chamber 10, the power may be received from the RF power source 50, and thus, the gas injection part 30 may serve as an upper electrode.

The RF power source 50 may supply power to generate the plasma. That is, the RF power source 50 may supply the power to generate the plasma in the reaction space inside the chamber 10. For example, the RF power source 50 may supply the power to any one of the substrate support part 20 or the gas injection part 30, and the other one of the substrate support part 20 or the gas injection part 30 may be grounded to generate the plasma in a space between the substrate support part 20 and the gas injection part 30.

The method for forming the solar cell in accordance with an exemplary embodiment may be performed using the substrate processing apparatus. That is, in the method for forming the solar cell in accordance with an exemplary embodiment, a hole transport layer 500 including a nitrogen (N)-doped nickel oxide thin film (N: NiOₓ) may be formed using the substrate processing apparatus to form the solar cell.

The method for forming the solar cell in accordance with an exemplary embodiment includes a process of forming a charge transport layer. That is, the method for forming the solar cell in accordance with an exemplary embodiment may include a process of forming at least one charge transport layer of the first charge transport layer and the second charge transport layer. Here, the first charge transport layer may include an electron transport layer 300 that serves to transport an electron generated from a light absorption layer 400 to the first electrode layer 200, and the second charge transport layer may include a hole transport layer 500 that serves to transport a hole generated from the light absorption layer 400 to the second electrode layer 600. For example, the charge transport layer may include the hole transport layer 500, but an exemplary embodiment is not limited thereto and may be equally applied in even case in which the electron transport layer 300 is formed to manufacture the solar cell.

The process of forming the hole transport layer 500 may include a process of preparing a substrate 100 in a reaction space, a process of supplying a raw material including a metal into the reaction space, and a process of supplying a reactant gas including an oxygen-containing gas and a nitrogen-containing gas into the reaction space.

In the process of preparing the substrate 100, the substrate 100 may be loaded to be prepared in the reaction space of the chamber 10. The substrate 100 loaded into the reaction space may be seated on a substrate support part 20. Here, the substrate 100 may include a transparent substrate or opaque substrate, and the transparent substrate may include a glass or plastic substrate. The substrate 100 may be provided in the chamber 10 in a state in which a first electrode layer 200, an electron transport layer 300, and a light absorption layer 400 are already formed on the substrate. Before performing the process of forming the hole transport layer 500, a process of forming at least one of the first electrode layer 200, the electron transport layer 300, or the light absorption layer 400 in the chamber 10 may be performed. Here, the substrate support part 20 may be provided with an electrostatic chuck to adsorb and maintain the substrate by using electrostatic force so that the substrate 10 is seated and supported. Alternatively, the substrate support part 20 may support the substrate through vacuum adsorption or mechanical force.

The process of forming the hole transport layer 500 may include a process of supplying a source gas including a metal into the reaction space, in which the substrate 100 on which the light absorption layer 400 is formed is prepared, and a process of supplying a reactant gas including an oxygen-containing gas and a nitrogen-containing gas into the reaction space. Here, in the process of forming the hole transport layer 500, the hole transport layer 500 may be formed through a chemical vapor deposition process or an atomic layer deposition process. For example, at least some of the process of supplying the source gas and the process of supplying the reactant gas may be performed at the same time to form the hole transport layer 500 through the chemical vapor deposition process. In addition, the process of supplying the source gas and the process of supplying the reactant gas may be sequentially performed to form the hole transport layer 500 through an atomic layer deposition process.

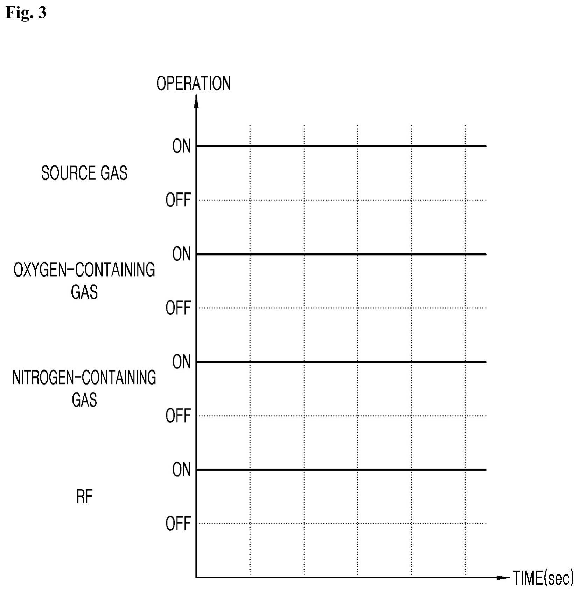

For example, when the hole transport layer 500 is formed through the chemical vapor deposition process, as illustrated in FIG. 3, the process of supplying the source gas and the process of supplying the reactant gas may be performed at the same time.

In the process of supplying the source gas, a metal-containing gas may be supplied to the substrate on which the light absorption layer 400 is formed. Here, the metal-containing gas may include a nickel (Ni)-containing gas. Here, in the process of supplying the source gas, the source gas including a nickel (Ni)-containing gas may be supplied to the substrate through the gas injection part 30 of the substrate processing apparatus.

At least some of the process of supplying the reactant gas may be performed at the same time with the process of supplying the source gas. Here, at least one of an oxygen (O)-containing gas and a nitrogen (N)-containing gas may be supplied at the same time to the reactant gas or supplied in a set order. Here, the oxygen (O)-containing gas may include at least one of an oxygen (O₂) gas, an ozone (O₃) gas, or water vapor (H₂O). Alternatively, the oxygen (O)-containing gas may include various gases containing oxygen (O). The nitrogen (N)-containing gas may include at least one of a nitrous oxide (N₂O) gas or a nitrogen (N₂) gas. Here, in the process of supplying the reactant gas, the oxygen (O)-containing gas and the nitrogen (N)-containing gas may be supplied at the same time while the source gas is supplied, the nitrogen (N)-containing gas may be supplied after the oxygen (O)-containing gas is supplied while the source gas is supplied, or the oxygen (O)-containing gas may be supplied after the nitrogen (N)-containing gas is supplied while the source gas is supplied. In FIG. 3, an embodiment in which the oxygen (O)-containing gas and the nitrogen (N)-containing gas are supplied at the same time is illustrated, but the supply timing of the oxygen (O)-containing gas and the nitrogen (N)-containing gas may be changed in various manners while the source gas is supplied.

Here, the RF power source 50 may be applied to the reaction space. That is, the process of forming the hole transport layer 500 may further include a process of applying power for forming the plasma in the reaction space. Here, the process of applying RF power to the reaction space may include all cases in which the RF power is applied while the processes of supplying the source gas and the reactant gas are performed. Here, the RF power may be applied before the supplying of the source gas and the reactant gas into the reaction space start or while the source gas and the reactant gas are supplied, or the RF power may be intermittently applied, i.e., be applied in the form of a pulse while the source gas and the reactant gas are supplied into the reaction space.

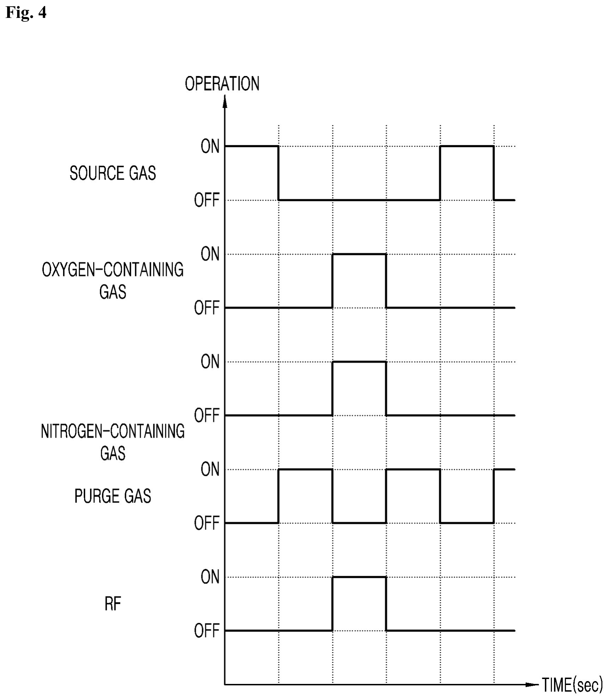

When the hole transport layer 500 is formed through the atomic layer deposition process, as illustrated in FIG. 4, the process of supplying the source gas and the process of supplying the reactant gas may be performed sequentially. In this case, the process of forming the hole transport layer 500 may include a process of supplying a metal-containing gas, that is, a source gas containing a metal, to the reaction space, a process of purging the reaction space, into which the source gas is supplied, a process of supplying a reactant gas, in which the oxygen (O)-containing gas and the nitrogen (N)-containing gas are mixed, to the reaction space and a process of purging the reaction space, into which the reactant gas is supplied.

In the process of supplying the source gas, a metal-containing gas may be supplied to the substrate on which the light absorption layer 400 is formed. Here, the metal-containing gas may include a nickel (Ni)-containing gas. Here, in the process of supplying the source gas, the source gas including a nickel (Ni)-containing gas may be supplied to the substrate through the gas injection part 30 of the substrate processing apparatus. In the process of supplying the source gas, the source gas containing nickel (Ni) may be injected to be adsorbed.

After the process of supplying the source gas, the process of purging the reaction space into which the source gas is supplied may be performed. In the process of purging the reaction space in which the source gas is supplied, the source gas remaining the reaction space of the chamber 10 may be removed. This may be performed by supplying an inert gas, for example, an argon (Ar) gas into the reactant gas, and the argon (Ar) gas may be supplied through the gas injection part 30 of the substrate processing apparatus.

After the process of purging the reaction space into which the source gas is supplied, the process of supplying the reactant gas may be performed. In the process of supplying the reactant gas, the reactant gas in which the oxygen (O)-containing gas and the nitrogen (N)-containing gas are mixed may be supplied to the substrate. Here, the oxygen (O)-containing gas may include at least one of an oxygen (O₂) gas, an ozone (O₃) gas, or water vapor (H₂O). Alternatively, the oxygen (O)-containing gas may include various gases containing oxygen (O). In addition, the nitrogen (N)-containing gas may include at least one of the nitrous oxide (N₂O) gas and the nitrogen (N₂) gas, and also, various gases containing nitrogen (N) may be provided.

On the other hand, in the process of supplying the reactant gas, the oxygen (O)-containing gas, for example, the oxygen (O₂) gas and the nitrogen (N)-containing gas, for example, the nitrous oxide (N₂O) gas may be supplied in the set order. That is, in the process of supplying the reactant gas, the nitrous oxide (N₂O) gas may be supplied after supplying the oxygen (O₂) gas, or the oxygen (O₂) gas may be supplied after supplying the nitrous oxide (N₂O) gas. In FIG. 4, an embodiment in which the oxygen (O)-containing gas and the nitrogen (N)-containing gas are supplied at the same time in the process of supplying the reactant gas is illustrated, but the supply timing of the oxygen (O)-containing gas and the nitrogen (N)-containing gas may be changed in various manners in the process of supplying the reactant gas.

As described above, when the reactant gas is supplied to the substrate on which the raw material is adsorbed, the raw material may react with the reaction material contained in the reactant gas.

Here, in the process of supplying the reactant gas, the RF power may be applied to the reaction space so that the reactant gas may be activated to reactively react with the source gas, thereby generating the plasma. That is, the process of forming the hole transport layer 500 may further include a process of applying the power for forming the plasma to the reaction space. Here, at least some of the process of supplying the reactant gas may be performed while the power for forming the plasma is applied to the reaction space. That is, at least partial section of a section in which the process of supplying the reactant gas is performed may overlap a section in which the power forming the plasma is applied to the reaction space. The process of applying the RF power to the reaction space may include all cases in which the RF power is applied while the process of supplying the reactant gas is performed. Here, the RF power may be applied before the supplying of the reactant gas to the reaction space starts or after the supplying of the reactant gas to the reaction space, or the RF power may be intermittently applied, i.e., be applied in the form of a pulse while the reactant gas are supplied.

As described above, in the process of supplying the reactant gas, the reactant gas may be activated to be supplied so that the supplied reactant gas is activated with oxygen radicals and nitrogen radicals. As a result, the hole transport layer 500 including a nickel oxide thin film (N: NiOₓ) doped with nitrogen (N) may be formed on the substrate at a low process temperature, for example, a temperature of 50°C to 100°C. As described above, the hole transport layer 500 may be formed by maintaining the temperature of the reaction space below 100°C to prevent the light absorption layer 400 formed on the substrate from being damaged at the high temperature.

Here, in the process of supplying the reactant gas, the oxygen-containing gas may be supplied at the same amount as the nitrogen-containing gas or at an amount greater than that of the nitrogen-containing gas. For example, in the process of supplying the reactant gas, the oxygen-containing gas may be supplied at an amount greater than that of the nitrogen-containing gas, and the oxygen-containing gas and the nitrogen-containing gas may be supplied at a ratio of 5:1 to 5:4. If the supply amount of nitrogen-containing gas increases, an electrical resistance rate may exceed 100 Ωcm, and electrical properties may be deteriorated, and if the supply amount of nitrogen-containing gas decreases, light transmittance may increase to 85% or more, more particularly, 85% to 95%.

After the process of supplying the reactant gas, the process of purging the reaction space into which the reactant gas is supplied may be performed. In the process of purging the reaction space in which the reactant gas is supplied, the reactant gas remaining the reaction space of the chamber 10 may be removed. Like the process of purging the source gas, the process of purging the reactant gas may be performed by supplying the inert gas, for example, the argon (Ar) gas to the reactant gas. The argon (Ar) gas may be supplied through at least one passage of a source gas supply passage and a reactant gas supply passage as described above.

Here, the process of forming the hole transport layer 500 in accordance with an exemplary embodiment may be performed by performing a process cycle including the process of supplying the source gas, the process of purging the source gas, the process of supplying the reactant gas, and the process of purging the reactant gas several times. That is, in the process of forming the hole transport layer 500, the process of supplying the source gas, the process of purging the source gas, the process of supplying the reactant gas, and the process of purging the reactant gas may form one process cycle, and the process cycle may be repeated performed until the hole transport layer 500 is formed to a desired thickness on the substrate. Here, the hole transport layer 500 may be formed to a thickness of 10 Å to 100 Å. If the thickness of the hole transport layer 500 is less than 10 Å, the hole generated from the light absorption layer 400 may not be efficiently collected and transferred to the second electrode layer 600. In addition, if the thickness of the hole transport layer 500 exceeds 100 Å, there may be a limitation in that the light transmittance decreases as described above.

As described above, after process of forming the hole transport layer 500, a process of supplying the nitrogen-containing gas or the oxygen-containing gas to the reaction space may be further performed. In addition, after the process of forming the hole transport layer 500, a process of applying the power for forming the plasma in the reaction space may be further performed. Here, the nitrogen-containing gas may include at least one of the nitrous oxide (N₂O) gas and the nitrogen (N₂) gas, and the oxygen-containing gas may include various gases containing oxygen (O) such as an oxygen (O₂) gas, an ozone (O₃) gas, water vapor (H₂O), and the like. In this case, nitrogen plasma or oxygen plasma may be formed in the reaction space. As described above, after the process of forming the hole transport layer 500, the nitrogen plasma or the oxygen plasma may be formed to improve a film quality, or an amount of nitrogen or oxygen contained in the hole transport layer 500 may be additionally controlled.

Here, the method for forming the solar cell in accordance with an exemplary embodiment may be performed by performing a process cycle including the process of supplying the nitrogen-containing gas or the oxygen-containing gas to the reaction space and the process of applying the power for forming the plasma to the reaction space several times. That is, the process of supplying the nitrogen-containing gas or the oxygen-containing gas to the reaction space and the process of applying the power for forming the plasma to the reaction space may form one process cycle, and the process cycle may be repeatedly performed until the film quality of the hole transport layer 500 reaches a desired level or until the control of the nitrogen or oxygen content contained in the hole transport layer 500 is completed. In this case, as described above, the process of supplying the source gas, the process of purging the source gas, the process of supplying the reactant gas, and the process of purging the reactant gas may form a first process cycle, and the process of supplying the nitrogen-containing gas or the oxygen-containing gas to the reaction space and the process of applying the power for forming the plasma to the reaction space may form a second process cycle. Here, each of the first process cycle and the second process cycle may be performed several times.

In the method for forming the solar cell in accordance with an exemplary embodiment, the metal oxide thin film may be formed through the chemical vapor deposition process or the atomic layer deposition process, and the metal oxide thin film may be processed using the nitrogen-containing gas to form the charge transport layer. Here, the charge transport layer may include the hole transport layer 500, but is not limited thereto, and may be equally applied even if the electron transport layer 300 is applied.

That is, the method for forming the solar cell in accordance with an exemplary embodiment may be a method for forming the solar cell, which includes the process of forming the hole transport layer 500, and the process of forming the hole transport layer 500 may include a process of preparing the substrate 100 in the reaction space, a process of forming the metal oxide thin film by supplying the source gas containing the metal and the reactant gas containing the oxygen-containing gas to the reaction space, and a process of supplying the nitrogen-containing gas to the metal oxide thin film.

Here, in the process of forming the metal oxide thin film, the metal-containing gas, i.e., the nickel-containing gas may be supplied to the reaction space, and the oxygen-containing gas may be supplied to the reactant gas to form the nickel oxide thin film (NiOₓ). Here, in the process of forming the metal oxide thin film, the metal oxide thin film may be formed through the chemical vapor deposition process, in which the source gas and the reactant gas are supplied at the same time, or the atomic layer deposition process, in which the source gas and the reactant gas are sequentially supplied. As described above, the process of supplying the source gas and the reactant gas to form the metal oxide thin film may be performed repeatedly until the metal oxide thin film is formed at the desired thickness on the substrate.

In the process of supplying the nitrogen-containing gas, the nitrogen-containing gas, for example, at least one of the nitrous oxide (N₂O) or the nitrogen (N₂) gas may be supplied to the reaction space. That is, in the process of supplying the nitrogen-containing gas, the nitrogen-containing gas may be supplied to the metal oxide thin film formed on the substrate. Here, the process of forming the hole transport layer 500 may further include a process of applying the power for forming the plasma to the reaction space. Here, at least some of the process of supplying the nitrogen-containing gas to the metal oxide thin film may be performed while the power for forming the plasma is applied to the reaction space. As described above, the process of supplying the nitrogen-containing gas and the process of applying the power for forming the plasma to the reaction space may be repeatedly performed. In addition, as described above, the process of supplying the source gas and the reactant gas may form a first process cycle, and the process of supplying the nitrogen-containing gas and the process of applying the power for forming the plasma to the reaction space may form a second process cycle. Here, each of the first process cycle and the second process cycle may be performed several times.

As described above, if the nitride thin film is exposed to the nitrogen plasma by supplying the nitrogen-containing gas to the reaction space and applying the power for forming the plasma, the nitrogen may be doped into the nickel oxide (NiOₓ) thin film to form the nickel oxide thin film (N: NiOₓ) that is doped with nitrogen (N). In addition, if the nitrogen plasma is formed in the reaction space to dope the nickel oxide oxide (NiOₓ) thin films, stress of the thin film may be adjusted to effectively remove impurities remaining in the chamber 10 or impurities contained in the nickel oxide (NiOₓ) thin film.

In addition, in the method for forming the solar cell in accordance with an exemplary embodiment, the nitrogen-doped metal thin film may be formed through the chemical vapor deposition process or the atomic layer deposition process, and the nitrogen-doped metal thin film may be processed using the oxygen-containing gas to form the charge transport layer. Here, the charge transport layer may include the hole transport layer 500, but is not limited thereto, and may be equally applied even if the electron transport layer 300 is applied.

That is, the method for forming the solar cell in accordance with an exemplary embodiment may be a method for forming the solar cell, which includes the process of forming the hole transport layer 500, and the process of forming the hole transport layer 500 may include a process of preparing the substrate 100 in the reaction space, a process of forming the nitrogen-doped metal thin film by supplying the source gas containing the metal and the reactant gas containing the nitrogen-containing gas to the reaction space, and a process of supplying the oxygen-containing gas to the nitrogen-doped metal thin film.

Here, in the process of forming the nitrogen-doped metal thin film, the metal-containing gas, i.e., the nickel-containing gas as the source gas may be supplied to the reaction space, and the nitrogen-containing gas, for example, at least one of nitrous oxide (N₂O) or nitrogen (N₂) gas as the reactant gas may be supplied to form the nitrogen-doped nickel thin film. Here, in the process of forming the nitrogen-doped metal thin film, the nitrogen-doped metal thin film may be formed through the chemical vapor deposition process, in which the source gas and the reactant gas are supplied at the same time, or the atomic layer deposition process, in which the source gas and the reactant gas are sequentially supplied. As described above, the process of supplying the source gas and the reactant gas to form the nitrogen-doped metal thin film may be performed repeatedly until the metal thin film is formed at the desired thickness on the substrate.

In the process of supplying the oxygen-containing gas, a gas containing oxygen (O) may be supplied to the reaction space. That is, in the process of supplying the oxygen-containing gas, the oxygen-containing gas may be supplied to the nitrogen-doped metal thin film formed on the substrate. Here, the process of forming the hole transport layer 500 may further include a process of applying the power for forming the plasma to the reaction space. Here, at least some of the process of supplying the oxygen-containing gas to the nitrogen-doped metal thin film may be performed while the power for forming the plasma is applied to the reaction space. As described above, the process of supplying the oxygen-containing gas and the process of applying the power for forming the plasma to the reaction space may be repeatedly performed. In addition, as described above, the process of supplying the source gas and the reactant gas may form a first process cycle, and the process of supplying the oxygen-containing gas and the process of applying the power for forming the plasma to the reaction space may form a second process cycle. Here, each of the first process cycle and the second process cycle may be performed several times.

In accordance with the exemplary embodiments, the light transmittance of the charge transport layer formed through the deposition process may increase.

That is, the light transmittance may increase while minimizing the deterioration in the electrical properties of the charge transport layer. Therefore, the solar light may effectively pass through the charge transport layer and be absorbed by the light absorption layer to improve the photoelectric conversion efficiency.

Although the specific embodiments are described and illustrated by using specific terms, the terms are merely examples for clearly explaining the embodiments, and thus, it is obvious to those skilled in the art that the embodiments and technical terms can be carried out in other specific forms and changes without changing the technical idea or essential features. Therefore, it should be understood that simple modifications in accordance with the embodiments of the present invention may belong to the technical spirit of the present invention.

## Claims

1. A solar cell comprising:
a substrate;
a first charge transport layer provided on the substrate;
a light absorption layer provided on the first charge transport layer;
a second charge transport layer provided on the light absorption layer; and
an electrode layer provided on the second charge transport layer,
wherein at least one of the first charge transport layer or the second charge transport layer is formed using an oxygen-containing gas and a nitrogen-containing gas.

2. The solar cell of claim 1, wherein the second charge transport layer comprises a hole transport layer, and
the hole transport layer is formed using the oxygen-containing gas and the nitrogen-containing gas.

3. The solar cell of claim 2, wherein the hole transport layer has a thickness of 10 Å to 100 Å.

4. The solar cell of claim 2, wherein the hole transport layer has light transmittance of 85% to 95% and an electrical resistance rate of 10 Ωcm to 100 Ωcm.

5. The solar cell of claim 2, wherein the hole transport layer comprises a nitrogen-containing nickel oxide thin film.

6. A method for forming a solar cell, which comprises forming a charge transport layer,
wherein the forming of the charge transport layer comprises:
preparing a substrate in a reaction space;
supplying a source gas containing a metal to the reaction space; and
supplying a reactant gas comprising an oxygen-containing gas and a nitrogen-containing gas to the reaction space.

7. The method of claim 6, wherein at least some of the supplying of the source gas and the supplying of the reactant gas are performed at the same time.

8. The method of claim 6, wherein the supplying of the source gas and the supplying of the reactant gas are sequentially performed.

9. The method of claim 8, wherein the forming of the charge transport layer further comprises:
purging the reaction space into which the source gas is supplied; and
purging the reaction space into which the reactant gas is supplied.

10. The method of claim 9, wherein a process cycle comprising the supplying of the source gas, the purging of the reaction space into which the source gas is supplied, the supplying of the reactant gas, and the purging of the reaction space into which the reactant gas is supplied is performed several times.

11. The method of any one of claims 6 to 9, wherein the supplying of the reactant gas comprises supplying the oxygen-containing gas and the nitrogen-containing gas at the same time.

12. The method of any one of claims 6 to 9, wherein the supplying of the reactant gas comprises supplying the oxygen-containing gas and the nitrogen-containing gas in a set order.

13. The method of any one of claims 6 to 9, wherein, in the supplying of the reactant gas, the oxygen-containing gas is supplied at the same amount as the nitrogen-containing gas or at an amount greater than that of the nitrogen-containing gas.

14. The method of claim 6, wherein the forming of the charge transport layer further comprises applying power for forming plasma to the reaction space, and
at least a portion of the supplying of the reactant gas is performed while the power for forming the plasma is applied to the reaction space.

15. The method of claim 6, wherein the source gas comprises a nickel (Ni)-containing gas,
the oxygen-containing gas comprises an oxygen (O₂) gas, and
the nitrogen-containing gas comprise a nitrous oxide (N₂O) gas.

16. The method of claim 6, further comprising, after the forming of the charge transport layer, supplying the nitrogen-containing gas or the oxygen-containing gas to the reaction space.

17. The method of claim 6, further comprising, after the forming of the charge transport layer, applying power for forming plasma to the reaction space.

18. The method of claim 17, wherein a process cycle comprising the supplying of the nitrogen-containing gas or the oxygen-containing gas to the reaction space and the applying of the power for forming the plasma to the reaction space is performed several times.

19. A method for forming a solar cell, which comprises forming a charge transport layer,
wherein the forming of the charge transport layer comprises:
preparing a substrate in a reaction space;
supplying a source gas containing a metal and a reactant gas containing an oxygen-containing gas to the reaction space to form a metal oxide thin film; and
supplying a nitrogen-containing gas to the metal oxide thin film.

20. The method of claim 19, wherein the forming of the charge transport layer further comprises applying power for forming plasma to the reaction space,
wherein at least a portion of the supplying of the nitrogen-containing gas to the metal oxide thin film is performed while the power for forming the plasma is applied to the reaction space.
